# EUROPEAN PATENT APPLICATION

(11) **EP 1 640 475 A2**
(43) Date of publication of application: **29.03.2006**
(21) Application number: 05251514.5
(22) Date of filing: 12.03.2005
(51) Int. Cl.: C23C 16/34, C23C 16/40, C23C 16/42

(54) **Precursor compounds for deposition of ceramic and metal films and preparation methods thereof**

(30) Priority: 12.03.2004 KR 2004016960
(71) Applicant: ROHM AND HAAS COMPANY, Philadelphia, Pennsylvania 19106-2399 (US)
(72) Inventor: Shin, Hyun Kook, Paldal-gu Suwon Kyungki-Do 442-470 (KR)
(74) Representative: Buckley, Guy Julian

(57) **Abstract**

The present invention relates to precursor compounds for the deposition of ceramic and metal films. It provides precursor compounds used for depositing on a silicon substrate ceramic and metal films, such as metal nitride, metal oxide, metal silicide, mixed metal nitrides, oxides, and silicides, and pure metals, preparation methods thereof, and methods for using said compounds to form films on said substrates.

## Description

### Background of the Invention

The present invention relates to precursor compounds for the deposition of ceramic and metal films. More particularly, the present invention relates to precursor compounds used for depositing on a silicon substrate ceramic and metal films, such as metal nitride, metal oxide, metal silicide, mixed metal nitrides, oxides, and silicides, and pure metals, to a preparation method thereof, and to a method for forming a film on a substrate using these compounds.

Generally, metal nitride films have interesting properties, including excellent hardness, high melting points, and resistance to organic solvents and acids. In particular, titanium nitride ("TiN"), tantalum nitride ("TaN"), and tantalum silicon nitride ("TaSiN") are used by the semiconductor industry as a diffusion barrier to prevent the aluminum ("Al") and copper ("Cu") used in (interconnect) wiring from diffusing into the silicon substrate.

Additionally, titanium ("Ti") and tantalum ("Ta") metal films are used as adhesive layers (glue layers) between silicon substrates and electrodes, interconnect materials, and diffusion barriers. These titanium and tantalum metal films form titanium silicide ("TiSi") and tantalum silicide ("TaSi") through reactions with the silicon layer when they are deposited on a silicon substrate. In this way, they are used as films for enhancing adhesion between the poorly adhesive silicon substrate and other metals (Al, Cu, TiN, etc.).

Moreover, metal oxide films such as alumina ("Al₂O₃"), titania ("TiO₂"), tantalum pentoxide ("Ta₂O₅"), and niobium pentoxide ("Nb₂O₅") are ceramic substances with a dielectric constant higher than that of silicon oxide ("SiO₂"), which has been longest used in the capacitors of semiconductor devices. Consequently, attempts are being made to use these metal oxide films in the capacitors of highly integrated, high-capacity memory semiconductors.

Films of the above-mentioned metal nitrides, metal oxides, metal silicides, and pure metals generally have been deposited by a method of physical vapor deposition called sputtering, which uses an electron beam ("e-beam") in the semiconductor manufacturing process. This method of physical vapor deposition forms a film on a silicon substrate when activated metal or ceramic particles jump out of a high-purity, solidified ceramic material called a target. These particles are activated by supplying an electron beam to the target in an ultrahigh vacuum.

However, in the manufacture of nanoscale semiconductor devices above 256MB, for example, 1GB and 4GB devices, circuit line width quickly drops in size to 0.25 µm, 0.11 µm, and 0.09 µm. With the sputtering-type physical vapor deposition currently used in 256MB DRAM (Dynamic Random Access Memory) and smaller devices, which has somewhat poorer step coverage, there are limits to applications such as filling processes for contact holes and via holes having aspect ratios with a high level of miniaturization.

In contrast with this, atomic layer deposition ("ALD") and chemical vapor deposition ("CVD"), which are used to deposit pure metal, metal nitride, metal oxide, and metal silicide films on substrates, exhibit high step coverage able to overcome the disadvantages of conventional physical vapor deposition. Therefore, application of these film deposition processes using ALD and CVD for the manufacture of nanoscale memory semiconductors continues to grow.

Playing the same role as the high-purity target of physical vapor deposition, high-purity organic (or inorganic) metal compounds called precursors are used in chemical vapor deposition and atomic layer deposition. Selecting suitable chemical compounds to serve as precursors can be said to be the most important, basic requirement for depositing pure metal, metal nitride, metal oxide, and metal silicide films with superior physical properties using chemical vapor deposition or atomic layer deposition.

In nanoscale semiconductor processes in particular, a multilayer interconnection structure is being used for chips in order to achieve miniaturization and high integration. This structure requires a variety of ALD and CVD techniques, which are needed for wiring, dielectric films, diffusion barriers, and electrodes. Different precursors are applied in the chemical vapor deposition and atomic layer deposition methods used for these films, and the complexity of the production process is increasing as a result. Development of excellent multipurpose precursors that can be used in chemical vapor deposition and atomic layer deposition is needed to achieve nanoscale semiconductor processes.

Metal nitride films and mixed metal nitride/silicide films are being used by the semiconductors industry as a diffusion barrier to prevent the aluminum and copper used in wiring from diffusing into the silicon substrate. Of these, the properties of tantalum nitride and tantalum silicon nitride films make them best suited for use as diffusion barriers.

The reasons for this are that tantalum nitride film created by atomic layer deposition and chemical layer deposition has a disordered grain boundary structure, so it is able to effectively prevent aluminum or copper from diffusing into the silicon substrate, and that tantalum has superior stability as it does not react with copper. Additionally, a ternary material such as a Ta-Si-N film has an amorphous structure and so, lacking a grain boundary, is able to effectively suppress the diffusion of copper.

Deposition of metal nitride (silicide) (e.g., TiN, ZrN, VN, TaN, NbN, TaSiN) films using atomic layer deposition or chemical vapor deposition generally employs a method by which a precursor, such as a metal chloride (MClₙ), metal fluoride (MFₙ) or metal amide (M(NR₂)ₙ), is subjected to pyrolysis under an atmosphere of nitrogen (N₂), argon (Ar) or ammonia (NH₃) and silane (SiH₄) gas.

In connection with this, steady development of related processes has continued since technology using titanium chloride ("TiCl₄") for the deposition of titanium nitride was introduced by A. E. Van Arkel and J. H. DeBoer in 1925. Processes using titanium amide (Ti(NR₂)₄ : R=Me (or CH₃), Et (or C₂H₅)) or Ti(NEtMe)₄ have been under development since the 1990s.

For TaN films created using atomic layer deposition or chemical vapor deposition, existing techniques include a method that uses an inorganic compound, such as TaF₅, TaCl₅, TaBr₅, and TaI₅, and a method that uses an organometallic compound, such as pentakis dimethylamino tantalum ("Ta(NMe₂)₅"), pentakis diethylamino tantalum ("Ta(NEt₂)₅"), pentakis ethylmethylamino tantalum ("Ta(NEtMe)₅"), and *t*-butylimino tris-diethylamino tantalum ("Me₃CN=Ta(NEt₂)₃"). However, these known compounds present several problems when used as precursors.

With solid inorganic compounds such as TaF₅, TaCl₅, TaBr₅, and TaI₅, it is difficult to obtain a sufficient, specific vapor pressure, which is a basic prerequisite for a precursor in the deposition process. Additionally, when metal halide compounds such as TaF₅ and TaCl₅ are used as precursors, F or Cl impurities fatal to the operation of a semiconductor device occasionally penetrate the film being deposited. Moreover, they are disadvantaged by requiring a high temperature for film deposition.

To overcome such disadvantages, tantalum-amides, which are liquid, organometallic compounds containing no halogen elements, which can be used for film deposition at relatively low temperatures, and which exhibit comparatively high vapor-pressure properties under deposition conditions, are being more widely used as precursors.

Of tantalum-amide compounds, pentakis dimethylamino tantalum is capable of serving as a particle source since, being a solid at ordinary temperatures, it allows for precursor condensation in the gas delivery tube and on the deposition reaction chamber walls during the process. Its use is limited, however, because providing reproducible gas pressure is difficult with solid compounds. In contrast with this, pentakis diethylamino tantalum, as a liquid compound at ordinary temperatures, exhibits vapor pressure permitting use under deposition-process conditions. However, pentakis diethylamino tantalum degrades the reliability of the deposition process because it is present as a 50:50 mixture since approximately 50% of the compound changes into an imido-tantalum compound (EtN=Ta(NEt₂)₃) when it is heated during the purification process to obtain a degree of purity sufficient for use. Additionally, a considerable quantity of carbon contamination is created in the TaN film being deposited.

Pentakis ethylmethylamino tantalum (Ta(NEtMe)₅) and *t*-butylimino tris-diethylamino tantalum have been developed to improve the amide-tantalum compounds mentioned above. Pentakis ethylmethylamino tantalum is a stable liquid compound with relatively high vapor pressure, and it has the very important advantage of producing little carbon contamination, compared with other tantalum-amide compounds, in the TaN film being deposited due to its ethylmethylamino group ligand characteristics. When heated to obtain high vapor pressure, however, part of the compound is thought to change into an imido compound, as is the case with Ta(NEt₂)₅. Additionally, it is also disadvantaged by the fact that the film deposited is generally the dielectric Ta₃N₅ rather than the conductor TaN.

*t*-Butylimino tris-diethylamino tantalum (Me₃CN=Ta(NEt₂)₃) is a stable liquid compound even when heated to above 100 degrees Celsius to increase vapor pressure. Compared with the dielectric Ta₃N₅, it is advantageous for the creation of a conductive TaN phase due to the presence of a strong imido double bond between Ta and N. It is disadvantaged, however, by problems involving phase durability because it is heated to temperatures above 100 degrees Celsius, and the Me₃CN=Ta(NEt₂)₃ precursor also involves production of more carbon contamination in the TaN film being deposited than occurs when a Ta(NEtMe)₅ precursor is used.

### Summary of the Invention

Consequently, considering the information provided above, there is great importance in selecting a suitable precursor to achieve successful film deposition using atomic layer deposition or chemical vapor deposition. The present inventor completed the present invention after research on the development of precursors that can be applied usefully to chemical vapor deposition and atomic layer deposition in nanoscale semiconductor processes due to these facts.

The present invention provides precursor compounds for the deposition of ceramic and metal films that improve significantly on the above-mentioned problems of precursor compounds for film deposition, and that can be applied usefully to the deposition of ceramic and metal films of metal nitride, metal oxide, metal silicide, mixed metal nitrides, oxides, and silicides, and pure metals. The present invention provides precursor compounds for the deposition of ceramic and metal films of Chemical Formula 1

RN=M(NR¹R²)ₙ₋₃[N(CH₃)C₂H₅] (Chemical Formula 1)

wherein M is a metal of the 3A, 4A, 5A, 3B, 4B, 5B, 6B, 7B, or 8B group in the periodic table; n is an integer from 3 to 6, and R, R¹ and R², which may be the same or different, are selected from the group consisting of alkyl, perfluoroalkyl, alkylaminoalkyl, alkoxyalkyl, silylalkyl, alkoxysilylalkyl, cycloalkyl, benzyl, allyl, alkylsilyl, alkoxysilyl, alkoxyalkylsilyl, and aminoalkylsilyl each such group having 1 to 8 hydrogen or carbon atoms, provided that when n = 5 and R is chosen from alkyl, silylalkyl, cycloalkyl and benzyl at least one of R¹ and R² is not methyl or ethyl.

Also, the present invention provides a method for preparing precursor compounds for the deposition of ceramic and metal films mentioned above.

### Brief Description of the Drawings

Fig. 1 shows a tantalum nitride film formed on a silicon substrate using a *tert*-butylimido tris-ethylmethylamino tantalum precursor according to the present invention.
Fig. 2 shows the composition of the tantalum nitride film deposited in Fig. 1.
Fig. 3 shows a niobium nitride film formed on a silicon substrate using a *sec*-butylimino tris-ethylmethylamino niobium precursor according to the present invention.
Fig. 4 shows the composition of the niobium nitride film deposited in Fig. 3.

### Detailed Description of the Invention

The following abbreviations used in the specification shall have the following meanings: MB = megabyte; GB = gigabyte; cm = centimeter; mm = millimeter; µm = micrometer; A = angstrom; mL = milliliter; g = gram; °C = degrees Celsius; Py = pyridine; Me = methyl; Et = ethyl; *i*-Pr = iso-propyl; *t*-Bu = tert-butyl; and *sec*-Bu = sec-butyl.

The present invention provides precursor compounds for the deposition of ceramic and metal films that improve significantly on the above-mentioned problems of precursor compounds for film deposition, and that can be applied usefully to the deposition of ceramic and metal films of metal nitride, metal oxide, metal silicide, mixed metal nitrides, oxides; and silicides, and pure metals. Precursor compounds for the deposition of ceramic and metal films of the present invention are those of Chemical Formula 1:

RN=M(NR¹R²)ₙ₋₃[N(CH₃)C₂H₅] (Chemical Formula 1)

wherein M is a metal of the 3A, 4A, 5A, 3B, 4B, 5B, 6B, 7B, or 8B group in the periodic table; n is an integer from 3 to 6, and R, R¹ and R², which may be the same or different, are selected from the group consisting of alkyl, perfluoroalkyl, alkylaminoalkyl, alkoxyalkyl, silylalkyl, alkoxysilylalkyl, cycloalkyl, benzyl, allyl, alkylsilyl, alkoxysilyl, alkoxyalkylsilyl, and aminoalkylsilyl each such group having 1 to 8 hydrogen or carbon atoms, provided that when n = 5 and R is chosen from alkyl, silylalkyl, cycloalkyl and benzyl at least one of R¹ and R² is not methyl or ethyl.

In compounds of Chemical Formula 1, an alkylsilyl or alkoxyalkylsilyl group with 1 to 4 carbon atoms, or an alkyl group with 1 to 6 carbon atoms is good for R, and R is preferably selected from the group consisting of (CH₃)₃Si, *t*-Bu₃Si, (CH₃O)₃Si, (CH₃)H₂Si, CH₃, C₂H₅, CH₃CH₂CH₂, *i*-Pr, *t*-Bu, *sec*-Bu and CH₃CH₂CH₂CH₂ in particular, and more preferably selected from among (CH₃)₃Si, *t*-Bu, and *i*-Pr.

Additionally, in compounds of Chemical Formula 1, R¹ and R², being either the same or different, are preferably selected from the group consisting of alkyls or alkylsilyls with 1 to 4 hydrogen or carbon atoms, and R¹ and R² are preferably each different and selected from CH₃ and C₂H₅. When n = 5 and R is chosen from alkyl, silylalkyl, cycloalkyl and benzyl, then at least one of R¹ and R² is not methyl or ethyl, and prefereably at least one of R¹ and R² is an alkyl having 3 to 8, preferably 3 to 4, carbon atoms.

M is preferably selected from metals of the 5B, 4B, and 4A groups. The value of "n" is the oxidation number of M. For example, where M is 5B group metal with a representative oxidation number of +5, n equals 5; where M is a 4B or 4A group metal with an oxidation number of +4, n equals 4; and where M is a 3A group metal with an oxidation number of +3, n equals 3.

Preferred compounds of Chemical Formula 1 are compounds of Chemical Formula 2:

RN=M[N(CH₃)C₂H₅]ₙ₋₃[N(CH₃)C₂H₅] (Chemical Formula 2)

where R is selected from the group consisting of (CH₃)₃Si, *t*-Bu₃Si, (CH₃O)₃Si, (CH₃)H₂Si, CH₃, C₂H₅, CH₃CH₂CH₂, *i*-Pr, *t*-Bu, *sec*-Bu and CH₃CH₂CH₂CH₂, M is a metal of the 3A, 4A, 5A, 3B, 4B, 5B, 6B, 7B, or 8B group in the periodic table; n is an integer from 3 to 6 that corresponds to the oxidation number of M and R¹ and R² are each different and selected from CH₃ and C₂H₅, provided that when n = 5 R is not CH₃, C₂H₅, CH₃CH₂CH₂, *i*-Pr, *t*-Bu, *sec*-Bu and CH₃CH₂CH₂CH₂. In one embodiment, M is a metal chosen from the 3A, 4A, 3B, 4B, 6B, 7B and 8B groups.

In compounds of Chemical Formula 1, M is preferably selected from metals of the 5B, 4B, and 4A groups, and more preferably selected from the group consisting of tantalum, niobium, hafnium, zirconium, titanium, silicon and germanium. In another embodiment, M is chosen from indium, gallium and aluminum. Even more preferable are compounds of Chemical Formula 3, where M is tantalum (Ta) and n equals 5; compounds of Chemical Formula 4, where M is niobium (Nb) and n equals 5; compounds of Chemical Formula 5, where M is hafnium (Hf) and n equals 4; and compounds of Chemical Formula 6, where M is titanium (Ti) and n equals 4.

RN=Ta[N(CH₃)C₂H₅]₃ (Chemical Formula 3)

RN=Nb[N(CH₃)C₂H₅]₃ (Chemical Formula 4)

RN=Hf[N(CH₃)C₂H₅]₂ (Chemical Formula 5)

RN=Ti[N(CH₃)C₂H₅]₂ (Chemical Formula 6)

In each of Chemical Formulae 3 and 4, R is selected from the group consisting of (CH₃)₃Si, *t*-Bu₃Si, (CH₃O)₃Si, and (CH₃)H₂Si. In each of Chemical Formulae 5 and 6, R is selected from the group consisting of (CH₃)₃Si, *t*-Bu₃Si, (CH₃O)₃Si, (CH₃)H₂Si, CH₃, C₂H₅, CH₃CH₂CH₂, *i*-Pr, *t*-Bu, *sec*-Bu and CH₃CH₂CH₂CH₂, and more preferably chosen from (CH₃)₃Si, *t*-Bu, and *i*-Pr.

Suitable compounds of Chemical Formula 3 are the compounds of Chemical Formula 8, where R is (CH₃)₃Si; and Chemical Formula 13, where R is (CH₃O)₃Si.

(CH₃)₃SiN=Ta[N(CH₃)C₂H₅]₃ (Chemical Formula 8)

(CH₃O)₃SiN=Ta[N(CH₃)C₂H₅]₃ (Chemical Formula 13)

Preferred compounds of Chemical Formula 4 are the compounds of Chemical Formula 15, where R is (CH₃)₃Si; and Chemical Formula 20, where R is (CH₃O)₃Si.

(CH₃)₃SiN=Nb[N(CH₃)C₂H₅]₃ (Chemical Formula 15)

(CH₃O)₃SiN=Nb[N(CH₃)C₂H₅]₃ (Chemical Formula 20)

Preferred compounds of Chemical Formula 5 are the compounds of Chemical Formula 21, where R is *t*-Bu, and Chemical Formula 22, where R is (CH₃)₃Si.

*t*-BuN=Hf[N(CH₃)C₂H₅]₂ (Chemical Formula 21)

(CH₃)₃SiN=Hf[N(CH₃)C₂H₅]₂ (Chemical Formula 22)

The precursor compounds of Chemical Formula 1 can be prepared by reacting an alkylamine with chloro-trimethylsilane in a nonpolar solvent, sequentially adding halide metal salts such as chloride metal salts and a Lewis base such as pyridine to the alkyltrimethylsilylamine thus produced to obtain a Lewis base complex of imido metal halide, reacting the Lewis base complex of imido metal halide thus produced with a lithium alkylamine solution, and then refluxing, stirring, filtering, and separating this. Toluene, benzene or hexane may be used as a nonpolar solvent, a metal chloride may be used for the halide metal salt, and pyridine or phosphine may be used for the Lewis base.

Preferably, as seen in Reaction Formula 1, metal chloride, which is a halide metal salt, and pyridine ("Py"), which is a Lewis base, are added sequentially to the alkyltrimethylsilylamine thus produced to create a pyridine complex of imido metal chloride, a hexane or pentane suspension of the pyridine complex of imido metal chloride thus produced is dripped into a hexane or pentane suspension in which is mixed lithium ethylmethylamine and optionally a lithium alkylamine either the same as or different from lithium ethylmethylamine, and then refluxed, stirred, filtered, and separated to produce the compound of Chemical Formula 1.

Reaction Formula 1

2(CH₃)₃SiCl + 4RNH₂ → 2R[(CH₃)₃Si]NH + 2RNH₃Cl

MClₙ + 2R[(CH₃)₃Si]NH + 3Py → RN=MClₙ₋₂:2Py + R[(CH₃)₃Si]₂NHCl + PyHCl

RN=MClₙ₋₂:2Py + Li[N(CH₃)C₂H₅] + (n-3)LiNR¹R² → RN=M(NR¹R²)ₙ₋₃N(CH₃)C₂H₅ + (n-2)LiCl + 2Py

In Reaction Formula 1, M, n, R, R¹ and R² are as defined in Chemical Formula 1.

The precursor compound of Chemical Formula 1, in addition to the above-mentioned methods, can be prepared through the process defined by Reaction Formula 2. In Reaction Formula 2, M, n, R, R¹ and R² are as defined in Chemical Formula 1.

Reaction Formula 2

MClₙ + (n-3)LiNR¹R² + Li[N(CH₃)C₂H₅] + LiNHR → RN=M(NR¹R²)ₙ₋₃N(CH₃)C₂H₅ + LiCl

However, yields are low and separation is not easy when preparing compounds of Chemical Formula 1 through the process of Reaction Formula 2. Therefore, preparation of compounds of Chemical Formula 1 through the process of Reaction Formula 1 is preferable.

The precursor compounds of Chemical Formula 1 according to the present invention can be applied usefully as precursor compounds for film deposition, and the compounds of Chemical Formulae 7 through 22 can be applied even more usefully in this way.

Of these compounds, *tert*-butylimido tris-ethylmethylamino tantalum defined by Chemical Formula 7 and trimethylsilylamido tris-ethylmethylamino tantalum defined by Chemical Formula 8 are very suitable for use as precursors for the deposition of tantalum nitride (TaN), tantalum oxide (Ta₂O₅), and tantalum silicon nitride (TaSiN) films. Additionally, *tert*-butylimido tris-ethylmethylamino niobium defined by Chemical Formula 14 and *tert*-butylimido tris-ethylmethylamino niobium defined by Chemical Formula 15 are very suitable for use as precursors for the deposition of niobium nitride (NbN) and niobium oxide (Nb₂O₅) films.

In particular, the compounds defined by Chemical Formula 7 and Chemical Formula 8 above are suitable for use as diffusion barriers for suppressing diffusion of wiring materials into silicon substrates in semiconductor devices. These compounds can have the following effects when used as precursors for the deposition of tantalum nitride (TaN) and tantalum silicon nitride (TaSiN).

First, the compounds of Chemical Formula 7 and Chemical Formula 8, compared with pentakis diethylamino tantalum or pentakis ethylmethylamino tantalum, are stable liquid compounds with high vapor pressure that do not change into mixtures even at temperatures with vapor pressure sufficient for chemical vapor deposition and atomic layer deposition of metal and ceramic films. They can be expected to improve reproducibility when applied to semiconductor production processes.

Second, the compounds of Chemical Formula 7 and Chemical Formula 8, compared with other metal alkylamide compounds, also have the very important advantage of reducing the possibility of carbon contamination penetrating a ceramic film during chemical vapor deposition due to their ethylmethylamide ligand properties.

Third, the compounds of Chemical Formula 7 and Chemical Formula 8, when used as precursors of chemical vapor deposition and atomic layer deposition processes for the deposition of tantalum nitride films, compared with the dielectric Ta₃N₅, are advantageous for the creation of a conductive TaN phase due to the presence in the compounds of a strong imido double bond between tantalum (Ta) and nitrogen (-N=Ta). This TaN phase is used as a diffusion barrier in semiconductor devices.

As described above, with the precursor compounds of Chemical Formula 1, an effective improvement has been achieved in terms of the thermal stability, vapor pressure, and film characteristics that are the weak points of compounds such as pentakis ethylmethylamino tantalum, which is the compound for the deposition of metal nitride films presented by Republic of Korea Patent No. 156980 previously registered by the present inventor. When these compounds are applied to processes for the production of semiconductor devices, they make possible reproducible film deposition, which is very important for production.

The present invention also provides a method of depositing a metal film on a substrate including the steps of providing a precursor gas including the compound of Chemical Formula 1, and contacting the substrate with the precursor gas.

Additionally, precursor compounds of Chemical Formula 1 according to the present invention are present in the liquid phase at ordinary temperatures or under deposition process conditions. Not only does this show easy control of delivery rates for precursor compounds, which is directly connected with process reproducibility in film deposition processes using the chemical vapor deposition method that employs a bubbler, but it also makes possible the use of direct liquid injector and liquid delivery systems, which are other methods of delivering precursor compounds in film deposition processes using chemical vapor deposition.

Accordingly, the present invention additionally provides a precursor compound solution for film deposition that can be employed usefully when the precursor compounds of Chemical Formula 1 are applied to liquid compound transfer devices such as direct liquid injectors and liquid delivery systems.

Chemical compounds of Chemical Formula 1 that are used in precursor compound solutions applied to the above-mentioned liquid compound transfer devices for the deposition of ceramic films may be used singly or mixed with two or more other compounds. A nonpolar solvent is used, and, in particular, solvents of hexane, methylcyclohexane, and ethylcyclohexane may be used.

Precursor compound solutions prepared in this way may be used very effectively in film depositions employing direct liquid injectors or liquid delivery systems. Precursor compound solutions may be prepared by dissolving compounds of Chemical Formula 1 in a purified, water-free solvent. The entire reaction process must take place under an atmosphere of nitrogen or argon, which are inert gases, because denaturation from contact with the air must be prevented.

If the above-mentioned precursor compound solutions are applied to chemical vapor deposition or atomic layer deposition, which are commonly used for the deposition of ceramic or metal films, it becomes possible to reproducibly form films on a substrate surface.

The present invention is described in greater detail below through the following examples. These examples are presented merely to aid understanding of the present invention, which is not limited them in any way.

### Embodiment 1

### Synthesis of tert-butylimido tris-ethylmethylamino tantalum

A solution of 500 mL of toluene added to 65 g (0.6 moles) of chloro-trimethylsilane is cooled using dry ice and an acetone bath (-78° C), and then 129 mL (1.23 moles) of *tert*-butylamine are added slowly under a nitrogen atmosphere. At this time, an exothermic reaction occurs along with generation of a white gas, and precipitation of white *tert*-butyl ammonium chloride salt occurs as a byproduct of the creation of *tert*-butyl trimethylsilylamine. After the addition of *tert*-butylamine is ended, the mixture is stirred for one hour at ordinary temperature to conclude the reaction.

500 mL of toluene are added to 100 g (0.28 moles) of tantalum pentachloride, and then stirred for one hour. The toluene suspension changes to a yellow color. A TEFLON™ tube is used to move this slowly into the *tert*-butyl trimethylsilylamine solution prepared as described. This light-yellow suspension is stirred for one hour, and then an excess of 85 mL (1.05 moles) of pyridine is added and the yellow-colored solution becomes clear. This solution is stirred overnight to conclude the reaction. To separate *tert*-butyl imido tantalum trichloride from a mixture containing the compound, the mixture is filtered under a nitrogen atmosphere to produce a gelatinous white solid and a first yellow-colored filtrate. The byproduct obtained from the filter is washed twice using a sufficient quantity of toluene and filtered to obtain a second filtrate, which is then combined with the first filtrate. A vacuum at ordinary temperature (20° C) is used to eliminate all volatile materials from the filtrate and obtain 120 g of a yellow-colored solid.

Hexane is added to 120 g of the yellow-colored *tert*-butyl imido tantalum trichloride, and then stirred to create a suspension. A TEFLON tube is used to slowly add this to a lithium ethylmethylamide hexane suspension, which is then stirred. (The heat of reaction generated at this time is slight and, therefore, not hazardous, and the reaction container is not cooled because the heat also contributes to the effective progress of the reaction.) When the solution is refluxed and stirred at 80° C for six hours to conclude the reaction, its color gradually changes to a dark brown and the reaction is completed.

Once the reaction is complete, to separate *tert*-butylimido tris-ethylmethylamino tantalum from a mixture containing *tert*-butylimido tris-ethylmethylamino tantalum according to the present invention, the mixture is fixed, and then the dark brown supernatant is carefully separated from the precipitate and filtered under a nitrogen atmosphere to obtain a brown filtrate. A sufficient quantity of hexane is once again added to the precipitate remaining after the supernatant is removed. This is stirred, and the suspended matter is allowed to settle. Supernatant is separated as before, filtered, and combined with the first filtrate. A vacuum at ordinary temperature (20° C) is used to eliminate all volatile materials from the filtrate and obtain a dark brown liquid. The desiccated dark-brown filtrate is distilled using a vacuum (10⁻² Torr or approximately 1.3 Nm⁻²) at 100° C to obtain a transparent, light-yellow distillate in a container cooled by liquid nitrogen. This first purified solution is purified using the same method at 80° C to obtain 80 g of an almost colorless, light-yellow, high-purity *tert*-butylimido tris-ethylmethylamino tantalum liquid.

The chemical reaction for the production of *tert*-butylimido tris-ethylmethylamino tantalum is shown in Reaction Formula 3. *tert*-Butylimido tris-ethylmethylamino tantalum purified to a high degree was verified by hydrogen nuclear magnetic resonance (NMR). The resulting analysis data and observed physical properties are the shown in Table 1 below.

Reaction Formula 3

2Me₃SiCl + 4*t*-BuNH₂ → 2*t*-Bu(Me₃Si)NH + 2*t*-BuNH₃Cl

TaCl₅ + 2*t*-Bu(Me3Si)NH + 3Py → *t*-BuNTaCl₃Py2 + *t*-Bu(Me₃Si)₂NHCl + PyHCl

*t*-BuNTaCl₃Py₂ + 3Li(NEtMe) → *t*-BuNTa(MEtMe)₃ + 3LiCl + 2Py

In the reaction formula above, Py represents pyridine.

### Embodiment 2

### Synthesis of sec-butylimido tris-ethylmethylamino tantalum

Using the same method as described in Embodiment 1, 124 mL (1.23 moles) of *sec*-butylamine are slowly added to 65 g (0.6 moles) of chloro-trimethylsilane. At this time, an exothermic reaction occurs, and precipitation of white *sec*-butyl ammonium chloride salt appears as a byproduct of the creation of *sec*-butyl trimethylsilylamine. After the addition of *sec*-butylamine is ended, the mixture is stirred for one hour at ordinary temperature to conclude the reaction.

A TEFLON tube is used to slowly move a yellow toluene suspension containing 100 g (0.28 moles) of tantalum pentachloride, prepared using the same method as described in Embodiment 1, into the *sec*-butyl trimethylsilylamine solution prepared as described. This solution is stirred for one hour, and then an excess of 85 mL (1.05 moles) of pyridine is added and the solution is stirred overnight to conclude the reaction. A vacuum at ordinary temperature (20° C) is used to eliminate all volatile materials from the yellow filtrate, obtained using the same filtration method as described in Embodiment 1, and obtain 120 g of a yellow-colored solid.

Hexane is added to 120 g of the yellow-colored *sec*-butyl imido tantalum trichloride prepared in this way, and then stirred to create a suspension. A TEFLON tube is used to slowly add this to a lithium ethylmethylamide suspension, and the reaction is initiated by the same method as described in Embodiment 1.

Once the reaction is complete, using a method identical to that described in Embodiment 1, the synthesized compound is separated to obtain 80 g of an almost colorless, light-yellow *sec*-butylimido tris-ethylmethylamino tantalum liquid.

The chemical reaction for the production of *sec*-butylimido tris-ethylmethylamino tantalum is shown in Reaction Formula 4 below. The compound obtained in this way was characterized by nuclear magnetic resonance. The resulting analysis data and observed physical properties are the shown in Table 1 below.

Reaction Formula 4

2Me₃SiCl + 4*sec*-BuNH₂ → 2*sec*-Bu(Me₃Si)NH + 2*sec*-BuNH₃Cl

TaCl₅ + 2*sec*-Bu(Me₃Si)NH + 3Py → *sec*-BuNTaCl₃Py₂ + *sec*-Bu(Me₃Si)₂NHCl + PyHCl

*sec*-BuNTaCl₃Py₂ + 3Li(NEtMe) → *sec*-BuNTa(NEtMe)₃ + 3LiCl + 2Py

### Embodiment 3

### Synthesis of isopropylimido tris-ethylmethylamino tantalum

Using the same method as described in Embodiment 1, 105 mL (1.23 moles) of isopropylamine are slowly added to 65 g (0.6 moles) of chloro-trimethylsilane. At this time, an exothermic reaction occurs, and precipitation of white isopropyl ammonium chloride salt appears as a byproduct of the creation of isopropyl trimethylsilylamine. After the addition of isopropylamine is ended, the mixture is stirred for one hour at ordinary temperature to conclude the reaction.

A TEFLON tube is used to slowly move a yellow toluene suspension containing 100 g (0.28 moles) of a tantalum pentachloride, prepared using the same method as described in Embodiment 1, into the isopropyl trimethylsilylamine solution prepared as described. This solution is stirred for one hour, and then an excess of 85 mL (1.05 moles) of pyridine is added and the solution is stirred overnight to conclude the reaction. A vacuum at ordinary temperature (20° C) is used to eliminate all volatile materials from the yellow filtrate, obtained using the same filtration method as described in Embodiment 1, and obtain 68 g of a yellow-colored solid.

Hexane is added to 68 g of the yellow-colored isopropylimido tantalum trichloride prepared in this way, and then stirred to create a suspension. A TEFLON tube is used to slowly add this to a lithium ethylmethylamide suspension, and the reaction is initiated by the same method as described in Embodiment 1 above.

Once the reaction is complete, using a method identical to that described in Embodiment 1, the synthesized compound is separated to obtain 45 g of an almost colorless, light-yellow isopropylimido tris-ethylmethylamino tantalum liquid.

The chemical reaction for the production of isopropylimido tris-ethylmethylamino tantalum is shown in Reaction Formula 5 below. The compound obtained in this way was characterized by nuclear magnetic resonance. The resulting analysis data and observed physical properties are the shown in Table 1 below.

Reaction Formula 5

2Me₃Si Cl + 4*i*-BuNH2 → 2*i*-Bu(Me₃Si)NH + 2*i*-BuNH₃Cl

TaCl₅ + 2*i*-Bu(Me₃Si)NH + 3Py → *i*-BuNTaCl₃Py₂ + *i*-Bu(Me₃Si)₂NHCl + PyHCl

*i*-BuNTaCl₃Py₂ + 3Li(NetMe) → *i*-BuNTa(NEtMe)₃ + 3LiCl + 2Py

### Embodiment 4

### Synthesis of trimethylsilylamido tris-ethylmethylamino tantalum

127 mL of 1,1,1,3,3,3-hexamethyldisilazane are slowly added to a yellow toluene suspension containing 100 g (0.28 moles) of tantalum pentachloride, prepared using the same method as described in Embodiment 1. This solution is stirred for one hour, and then an excess of 85 mL (1.05 moles) of pyridine is added and the solution is stirred overnight to conclude the reaction. A vacuum at ordinary temperature (20° C) is used to eliminate all volatile materials from the yellow filtrate, obtained using the same filtration method as described in Embodiment 1, and obtain 75 g of a yellow-colored solid.

Hexane is added to 75 g of the yellow-colored trimethylsilylamido tantalum trichloride prepared in this way, and then stirred to create a suspension. A TEFLON tube is used to slowly add this to a lithium ethylmethylamide suspension, and the reaction is initiated by the same method as described in Embodiment 1 above.

Once the reaction is complete, using a method identical to that described in Embodiment 1, the synthesized compound is separated to obtain 50 g of an almost colorless, light-yellow trimethylsilylamido tris-ethylmethylamino tantalum liquid.

The chemical reaction for the production of trimethylsilylamido tris-ethylmethylamino tantalum is shown in Reaction Formula 6 below. The compound obtained in this way was characterized by nuclear magnetic resonance. The resulting analysis data and observed physical properties are the shown in Table 1 below.

Reaction Formula 6

TaCl₅ + 2(Me₃Si)₂NH + 3Py → Me₃SiNTaCl₃Py₂ + (Me₃Si)₃NHCl + PyHCl

Me₃SiNTaCl₃Py₂ + 3Li(NEtMe) → Me₃SiNTa(NEtMe)₃ + 3LiCl + 2Py

### Embodiment 5

### Synthesis of tert-butylimido tris-ethylmethylamino niobium

A solution of 300 mL of toluene added to 65 g (0.6 moles) of chloro-trimethylsilane is cooled using dry ice and an acetone bath (-78° C), and then 129 mL (1.23 moles) of *tert*-butylamine are added slowly under a nitrogen atmosphere. At this time, an exothermic reaction occurs along with generation of a white gas, and precipitation of white *tert*-butyl ammonium chloride salt occurs as a byproduct of the creation of *tert*-butyl trimethylsilylamine. After the addition of *tert*-butylamine is ended, the mixture is stirred for one hour at ordinary temperature to conclude the reaction.

200 mL of toluene are added to 76 g (0.28 moles) of niobium pentachloride, and then stirred for one hour. The toluene suspension changes to a yellow color. A TEFLON tube is used to move this slowly into the *tert*-butyl trimethylsilylamine solution prepared as described. This yellow solution is stirred for one hour, and then an excess of 85 mL (1.05 moles) of pyridine is added and the solution is stirred overnight to conclude the reaction. To separate *tert*-butyl imido niobium trichloride from a mixture containing the compound, the mixture is filtered under a nitrogen atmosphere to produce a gelatinous white solid and a first filtrate. The byproduct obtained from the filter is washed twice using a sufficient quantity of toluene and filtered to obtain a second filtrate, which is then combined with the first filtrate. A vacuum at ordinary temperature (20° C) is used to eliminate all volatile materials from the filtrate and obtain 98 g of a yellow-colored solid.

Hexane is added to 98 g of the *tert*-butyl imido niobium trichloride, and then stirred to create a suspension. A TEFLON tube is used to slowly add this to a lithium ethylmethylamide hexane suspension, which is then stirred. (The heat of reaction generated at this time is slight and, therefore, not hazardous, and the reaction container is not cooled because the heat also contributes to the effective progress of the reaction.) When the solution is refluxed and stirred at 80° C for six hours to conclude the reaction, its color gradually changes to a dark yellow and the reaction is completed.

Once the reaction is complete, to separate *tert*-butylimido tris-ethylmethylamino niobium from a mixture containing *tert*-butylimido tris-ethylmethylamino niobium according to the present invention, the mixture is fixed, and then the dark yellow supernatant is carefully separated from the precipitate and filtered under a nitrogen atmosphere to obtain a first filtrate. A sufficient quantity of hexane is once again added to the precipitate remaining after the supernatant is removed. This is stirred, and the suspended matter is allowed to settle. Supernatant is separated as before, filtered, and combined with the first filtrate. A vacuum at ordinary temperature (20° C) is used to eliminate all volatile materials from the filtrate and obtain a dark yellow liquid. The desiccated dark-yellow filtrate is distilled using a vacuum (10⁻² Torr or approximately 1.3 Nm⁻²) at 100° C to obtain a transparent, yellow distillate in a container cooled by liquid nitrogen. This first purified solution is purified using the same method at 70° C to obtain 70 g of a yellow, high-purity *tert*-butylimido tris-ethylmethylamino niobium liquid.

The chemical reaction for the production of *tert*-butylimido tris-ethylmethylamino niobium is shown in Reaction Formula 7 below. *tert*-Butylimido tris-ethylmethylamino niobium purified to a high degree was characterized by nuclear magnetic resonance (NMR). The resulting analysis data and observed physical properties are the shown in Table 1 below.

Reaction Formula 7

2Me₃SiCl + 4*t*-BuNH₂ → 2*t*-Bu(Me₃Si)NH + 2*t*-BuNH₃Cl

NbCl₅ + 2*t*-Bu(Me₃Si)NH + 3Py → *t*-BuNNbCl₃Py₂ + *t*-Bu(Me₃Si)₂NHCl + PyHCl

*t*-BuNNbCl₃Py₂ + 3Li(NEtMe) → *t*-BuNNb(NEtMe)₃ + 3LiCl + 2Py

### Embodiment 6

### Synthesis of sec-butylimido tris-ethylmethylamino niobium

Using the same method as described in Embodiment 5 above, 124 mL (1.23 moles) of *sec*-butylamine are slowly added to 65 g (0.6 moles) of chloro-trimethylsilane. At this time, an exothermic reaction occurs along with generation of a white gas, and precipitation of white *sec*-butyl ammonium chloride salt appears as a byproduct of the creation of *sec*-butyl trimethylsilylamine. After the addition of *sec*-butylamine is ended, the mixture is stirred for one hour at ordinary temperature to conclude the reaction.

A TEFLON tube is used to slowly move a brown toluene suspension containing 76 g (0.28 moles) of niobium pentachloride, prepared using the same method as described in Embodiment 5 above, into the *sec*-butyl trimethylsilylamine solution prepared as described. This solution is stirred for one hour, and then an excess of 85 mL (1.05 moles) of pyridine is added, creating a milky suspension in the yellow solution, and the solution is stirred overnight to conclude the reaction of this suspension. A vacuum at ordinary temperature (20° C) is used to eliminate all volatile materials from a filtrate, obtained using the same filtration method as described in Embodiment 1 above, and obtain 103 g of a yellow-colored solid.

Hexane is added to 103 g of the *sec*-butyl imido niobium trichloride prepared in this way, and then stirred to create a suspension. A TEFLON tube is used to slowly add this to a lithium ethylmethylamide suspension, and the reaction is initiated by the same method as described in Embodiment 5 above.

Once the reaction is complete, using a method identical to that described in Embodiment 5, the synthesized compound is separated to obtain 68 g of *sec*-butylimido tris-ethylmethylamino niobium liquid.

The chemical reaction for the production of *sec*-butylimido tris-ethylmethylamino niobium is shown in Reaction Formula 8 below. The compound obtained in this way was characterized by nuclear magnetic resonance. The resulting analysis data and observed physical properties are the shown in Table 1 below.

Reaction Formula 8

2Me₃SiCl +4*sec*-BuNH₂ → 2*sec*-Bu(Me₃Si)NH + 2*sec*-BuNH₃Cl

NbCl₅ + 2*sec*-Bu(Me₃Si)NH + 3Py → *sec*-BuNNbCl₃Py₂ + *sec*-Bu(Me₃Si)₂NHCl + PyHCl

*sec*-BuNNbCl₃Py₂ + 3Li(NEtMe) → *sec*-BuNNb(NEtMe)₃ + 3LiCl + 2Py

### Embodiment 7

### Synthesis of tert-butylimido bis-ethylmethylamino hafnium

A solution of 50 mL of toluene added to 6.5 g (0.06 moles) of chloro-trimethylsilane is cooled using dry ice and an acetone bath (-78° C), and then 13 mL (0.124 moles) of *tert*-butylamine are added slowly under a nitrogen atmosphere. At this time, an exothermic reaction occurs along with generation of a white gas, and precipitation of white *tert*-butyl ammonium chloride salt occurs as a byproduct of the creation of *tert*-butyl trimethylsilylamine. After the addition of *tert*-butylamine is ended, the mixture is stirred for one hour at room temperature to conclude the reaction.

50 mL of toluene are added to 9 g (0.028 moles) of hafnium tetrachloride, and then stirred to produce a light-beige suspension. A TEFLON tube is used to move this slowly into the *tert*-butyl trimethylsilylamine solution prepared as described. This mixed suspension is stirred for one hour, and then an excess of 9 mL (0.11 moles) of pyridine is added and the solution is stirred overnight to conclude the reaction. To separate *tert*-butyl imido hafnium dichloride from the mixture, it is filtered under a nitrogen atmosphere to produce a first filtrate. The byproduct obtained from the filter is washed twice using a sufficient quantity of toluene and filtered to obtain a second filtrate, which is then combined with the first filtrate. A vacuum at ordinary temperature (20° C) is used to eliminate all volatile materials from the filtrate and obtain 6.5 g of a solid compound.

Hexane is added to 6.5 g of the solid compound prepared in this way, and then stirred to create a suspension. A TEFLON tube is used to slowly add this to a lithium ethylmethylamide hexane suspension, which is then stirred. (The heat of reaction generated at this time is slight and, therefore, not hazardous, and the reaction container is not cooled because the heat also contributes to the effective progress of the reaction.) When the solution is heated at this time, its color gradually changes to a dark brown and a mixture of other compounds is produced, so caution is required.

Once the reaction is complete, the mixture is fixed, and then the supernatant is carefully separated from the precipitate and filtered under a nitrogen atmosphere to obtain a first filtrate. A sufficient quantity of hexane is once again added to the precipitate remaining after the supernatant is removed. This is stirred, and the suspended matter is allowed to settle. Supernatant is separated as before, filtered, and combined with the first filtrate. A vacuum at ordinary temperature (20° C) is used to eliminate all volatile materials from the filtrate, which is then distilled using a vacuum (10⁻² Torr or approximately 1.3 Nm⁻²) to obtain a light-yellow distillate in a container cooled by liquid nitrogen. The distilled *tert*-butylimido bis-ethylmethylamino hafnium was characterized by nuclear magnetic resonance (NMR). The resulting analysis data and observed physical properties are the shown in Table 1 below.

**Table 1**

| | Compound | Phase (20° C) | Color | Nuclear Magnetic Resonance Analysis (Solvent: C₆D₅, Unit: ppm) |
|---|---|---|---|---|
| Embodiment 1 | *Tert*-butylimido tris-ethylmethylamino tantalum | Liquid | Light Yellow | 1.12 (t, 9H), 1.41 (s, 9H) 3.16 (s, 9H), 3.45 (q, 6H) |
| Embodiment 2 | *Sec*-butylimido tris-ethylmethylamino tantalum | Liquid | Light Yellow | 1.12 (m, 12H), 1.29 (d, 3H) 1.48 (m, 2H), 3.16 (s, 9H) 3.43 (q, 6H), 4.06 (m, 1H) |
| Embodiment 3 | Isopropylimido tris-ethylmethylamino tantalum | Liquid | Light Yellow | 1.13 (t, 9H), 1.30 (d, 6H) 3.16 (s, 9H), 3.43 (q, 6H) 4.35 (m, 1H) |
| | | | | |
| Embodiment 4 | Trimethylsilylamido tris-ethylmethylamino tantalum | Liquid | Light Yellow | 0.29 (s, 9H), 1.10 (t, 9H) 3.12 (s, 9H), 3.40 (q, 6H) 3.12 (s, 9H), 3.40 (q, 6H) |
| Embodiment 5 | *Tert*-butylimido tris-ethylmethylamino niobium | Liquid | Yellow | 1.14 (t, 9H), 1.41 (S, 9H) 3.18 (S, 9H), 3.46 (q, 6H) |
| Embodiment 6 | *Sec*-butylimido tris-ethylmethylamino niobium | Liquid | Yellow | 1.15 (m, 12H), 1.26 (d, 3H) 1.47 (m, 2H), 3.18 (s, 9H) 3.39 (q, 6H), 4.05 (m, 1H) |
| Embodiment 7 | *Tert*-butylimido bis-ethylmethylamino hafnium | Liquid | Yellow | 1.13 (t, 9H), 1.31 (s, 9H) 3.11 (s, 9H), 3.46 (q, 6H) |

### Embodiment 8

Preparation of precursor solution: mixture of *tert*-butylimido tris-ethylmethylamino tantalum and tetrakis-ethylmethylamino silicon

As described above, a solution was prepared by dissolving and mixing in an identical solvent tantalum and silicon compounds, including ethylmethylamino ligands, as a precursor solution for the deposition of tantalum silicon nitride (TaSiN) films that can be used as a diffusion barrier for suppressing the diffusion of wiring metals into a substrate. Potential reaction mechanisms in the deposition process were considered, and *tert*-butylimido tris-ethylmethylamino tantalum, which can act as a source of tantalum and nitrogen, and tetrakis-ethylmethylamino silicon, which can act as a source of silicon, were selected. Compounds containing ethylmethylamino ligands were selected to minimize the possibility of carbon impurities in the deposition reaction mechanism.

In a sealed container under a nitrogen atmosphere, 10 g of *tert*-butylimido tris-ethylmethylamino tantalum and 10 g of tetrakis-ethylmethylamino silicon liquid were mixed, and then dissolved in 100 mL of colorless methylcyclohexane to produce a colorless solution. The solution was left stationary at ordinary temperature under a nitrogen atmosphere for an extended period of at least one month, but no precipitation or change of color occurred. A vacuum was used to remove methylcyclohexane solvent, and then the solution was characterized by nuclear magnetic resonance. As a result, it was possible to confirm that *tert*-butylimido tris-ethylmethylamino tantalum and tetrakis-ethylmethylamino silicon were present without denaturation.

### Embodiment 9

### Preparation of sec-butylimido tris-ethylmethylamino niobium solution

*Sec*-butylimido tris-ethylmethylamino niobium with a molar concentration of 0. 1 was dissolved in methylcyclohexane under a nitrogen atmosphere to prepare a solution as in Embodiment 8. The solution was stored for an extended period of at least two months under a nitrogen atmosphere at ordinary temperature. Subsequent verification revealed no precipitation or change of color. A vacuum was used to remove methylcyclohexane solvent, and then the solution was characterized by nuclear magnetic resonance. As a result, it was possible to confirm that *sec*-butylimido tris-ethylmethylamino niobium was present without denaturation.

### Experimental Example 1

25 g of CVD precursor *tert*-butylimido tris-ethylmethylamino tantalum, prepared using the method described in Embodiment 1 above, were put in a container made of stainless steel under a nitrogen atmosphere, and then heated to 80° C. Under conditions in which a vacuum pump was operating to create a vacuum of 5 x 10⁻² Torr (approximately 6.5 Nm⁻²), the preparation was subjected to bubbling, and precursor gas required for deposition was sent in small quantities through the precursor delivery tube of the film deposition apparatus to the deposition container where the silicon substrate was located. The precursor compound delivery tube and container where the silicon substrate was placed for silicon film deposition used a heating jacket heated to 90° C to prevent precursor condensation. The 1 cm x 1 cm silicon substrate, which was coated with 2000 ' of SiO₂, used a separate heating device heated to 300° C for ceramic film deposition.

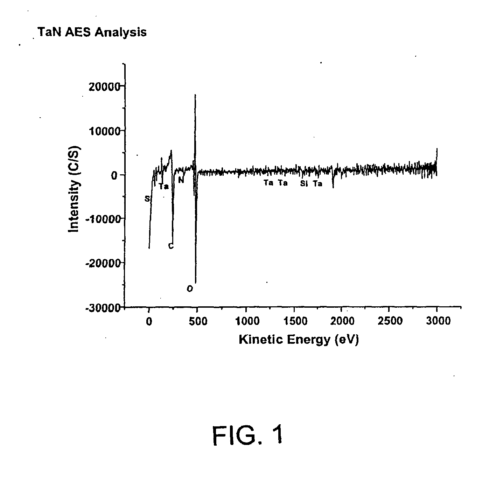

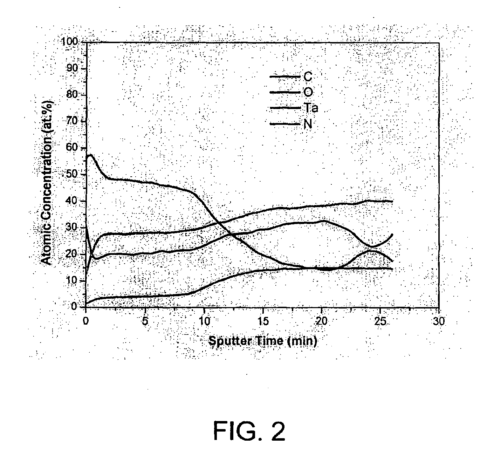

Through auger electron spectroscopy, as shown in Figs. 1 and 2, it was possible to verify that the tantalum nitride (TaN) film was deposited on the silicon oxide (SiO₂). After all the precursor was used, the precursor container was opened, revealing a clean interior free of foreign matter. In view of this fact, it was possible to confirm that the *tert*-butylimido tris-ethylmethylamino tantalum compound prepared according to Embodiment 1, as a precursor for chemical vapor deposition and atomic layer deposition, has thermal stability and vapor pressure sufficient for deposition.

This experiment, was performed to confirm that the deposited film was tantalum nitride (TaN), rather than to determine the composition of the deposited film. Therefore, no precautions were taken or adjustments made regarding carbon in the film or components of oxygen introduced from the outside.

### Experimental Example 2

Using a liquid precursor solution delivery system employing an evaporator, 10 mL of *sec*-butylimido tris-ethylmethylamino niobium solution, prepared according to Embodiment 9 above, were placed in the stopped end of a stainless steel tube, which was 15 mm in diameter and 300 mm in length and had one end stopped up, heated to 75° C, vaporized using a 5 x 10⁻² Torr (approximately 6.5 Nm⁻²) vacuum pump, and deposited by CVD at a deposition temperature of 300° C on a silicon substrate on which 2000 ' of silicon oxide (SiO₂) had been deposited. In this way, it was possible to deposit a niobium nitride (NbN) film. The 1 cm x 1 cm silicon substrate was placed in the middle of the tube, and a hot wire was wound around the middle of the tube where the silicon substrate was located and maintained at a temperature of 300° C. The entire deposition apparatus was maintained in a vacuum state using a 10⁻² Torr (approximately 1.3 Nm⁻²) vacuum pump.

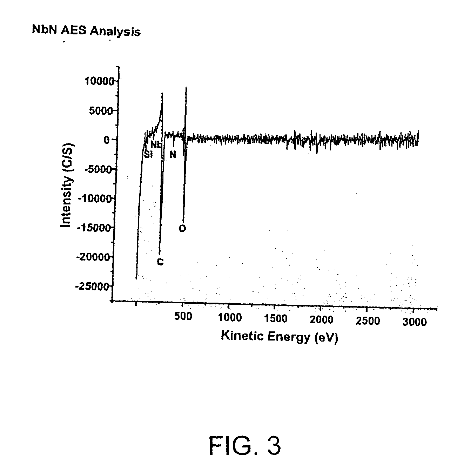

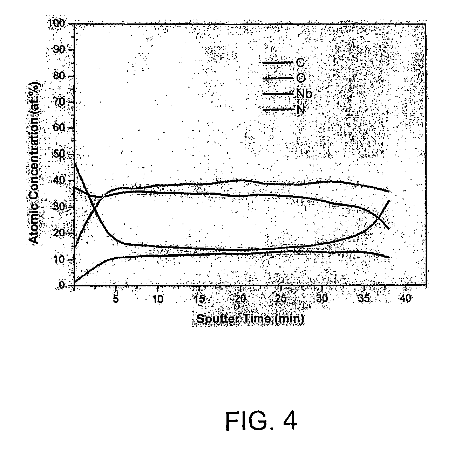

Through auger electron spectroscopy, as shown in Figs. 3 and 4, it was possible to verify that the deposited film was niobium nitride (NbN). After all the precursor was used, the tube that had contained the precursor was opened, revealing a clean interior. In view of this fact, it was possible to confirm that the *sec*-butylimido tris-ethylmethylamino niobium solution, as a precursor for chemical vapor deposition and atomic layer deposition, has superior vapor pressure and thermal stability.

This experiment, was performed to confirm that the deposited film was niobium nitride (NbN), rather than to determine the composition of the deposited film. Therefore, no precautions were taken or adjustments made regarding carbon in the film or components of oxygen introduced from the outside.

As seen above, precursor compounds for film deposition according to present invention are suitable for use in the deposition of ceramic and metal films. In particular, it can be seen that the precursor compounds developed by the present invention exhibit high vapor pressure and thermal stability unchanged even at high temperatures, which are superior properties for precursors in chemical vapor deposition and atomic layer deposition, and, therefore, that they can contribute significantly to improving reproducibility when applied to semiconductor production processes.

## Claims

1. A compound for the deposition of ceramic and metal films of Chemical Formula 1
RN=M(NR¹R²)ₙ₋₃[N(CH₃)C₂H₅] (Chemical Formula 1)
wherein M is a metal of the 3A, 4A, 5A, 3B, 4B, 5B, 6B, 7B, or 8B group in the periodic table; n is an integer from 3 to 6, and R, R¹ and R², which may be the same or different, are selected from the group consisting of alkyl, perfluoroalkyl, alkylaminoalkyl, alkoxyalkyl, silylalkyl, alkoxysilylalkyl, cycloalkyl, benzyl, allyl, alkylsilyl, alkoxysilyl, alkoxyalkylsilyl, and aminoalkylsilyl each such group having 1 to 8 hydrogen or carbon atoms, provided that when n = 5 and R is chosen from alkyl, silylalkyl, cycloalkyl and benzyl at least one of R¹ and R² is not methyl or ethyl.

2. The compound of claim 1 wherein R is selected from the group consisting of (CH₃)₃Si, *t*-Bu₃Si, (CH₃O)₃Si, (CH₃)H₂Si, CH₃, C₂H₅, CH₃CH₂CH₂, *i*-Pr, *t*-Bu, *sec*-Bu and CH₃CH₂CH₂CH₂.

3. The compound of claim 1 wherein R¹ and R², are either the same or different and are chosen from an alkyl group or alkylsilyl group each having 1 to 4 hydrogen or carbon atoms.

4. The compound of claim 1 wherein M is selected from group 5B, 4B, and 4A metals.

5. The compound of claim 1 wherien M is selected from the group consisting of indium, gallium, aluminum, silicon and germanium.

6. A method for preparing the compound of claim 1 comprising the steps of: reacting an alkylamine with chlorotrimethylsilane in a nonpolar solvent to produce an alkyltrimethylsilylamine; adding a halide metal salt and a Lewis base sequential to the alkyltrimethylsilylamine to produce a Lewis base-imido metal halide complex; and reacting the a Lewis base-imido metal halide complex with a lithium alkylamine.

7. The method of claim 6 wherein the Lewis base is chosen from pyridine and phosphine.

8. The method of claim 6 wherein the halide metal salt is a metal chloride.

9. A composition comprising the compound of claim 1 and a nonpolar solvent.

10. A method of depositing a metal film on a substrate comprising providing a precursor gas comprising the compound of claim 1, and contacting the substrate with the precursor gas.
